# EUROPEAN PATENT SPECIFICATION

(11) **EP 0 636 891 B1**
(45) Date of publication and mention of the grant of the patent: **06.10.2004**
(21) Application number: 94305511.1
(22) Date of filing: 26.07.1994
(51) Int. Cl.: G01R 25/00, G01S 7/491

(54) **Phase difference detecting method, circuit and apparatus**
Verfahren, Schaltung und Vorrichtung zur Phasendifferenzerfassung
Procédé, circuit et dispositif de détection de différence des phases

(30) Priority: 27.07.1993 JP 18511393
(43) Date of publication of application: 01.02.1995
(73) Proprietor: HAMAMATSU PHOTONICS K.K., Shizuoka-ken (JP)
(72) Inventor: Takeshima, Akira, c/o Hamamatsu Photonics K.K., Hamamatsu-shi, Shizuoka-ken (JP)
(74) Representative: Burke, Steven David

(56) References cited:
- EP-A- 0 559 274
- US-A- 4 739 383
- US-A- 4 957 362
- RESEARCH DISCLOSURE, no. 252, April 1985 GB, pages 187-189, 'Rangefinders'
- APPLIED OPTICS, vol. 29, no. 31, November 1990 NEW YORK US, pages 4578-4582, R.I.MACDONALD ET AL. 'Frequency domain optical reflectometer using a GaAs optoelectronic mixer'
- IEEE PHOTONICS TECHNOLOGY LETTERS, vol. 5, no. 12, December 1993 NEW YORK US, pages 1403-1406, Q.Z.LIU ET AL. 'Controlled Nonlinearity Monolithic Integrated Optoelectronic Mixing Receiver'
- PATENT ABSTRACTS OF JAPAN vol. 10 no. 140 (P-458) ,23 May 1986 & JP-A-60 260872 (MITSUBISHI) 24 December 1985,
- HOROWITZ ET AL: 'The Art of Electronics', 1980, CAMBRIDGE UNIVERSITY PRESS, CAMBRIDGE

## Description

### BACKGROUND OF THE INVENTION

### Field of the Invention

The present invention relates to a method, circuit, and apparatus for detecting a phase difference between an optical signal and an electrical signal.

### Related Background Art

A lot of PLL (Phase-Lock Loop) devices (phase comparator) and DBMs (Double-Balanced Mixers), both of which output a phase difference between two electrical signals, are commercially available as component devices. These component devices operate and output the phase differences between the electrical signals. For this reason, when a phase difference between a component of an intensity-modulated light and an electrical signal is measured, the optical signal must be converted into an electrical signal to measure the phase difference. Additionally, in these component devices, variations in intensity of an input electrical signal accordingly cause variations in phase difference output. Therefore, these component devices substantially need to be used at a constant input intensity.

As a phase difference detecting apparatus, a lock-in amplifier for outputting amplitude and phase difference information, a vector voltmeter mainly used in a high frequency region, or a phase meter for outputting only a phase difference is known. These apparatuses are constituted to obtain an accurate phase difference even when the input intensity varies to some extent. In these apparatuses, however, when a phase difference between a light intensity-modulated component and an electrical signal is to be measured, the optical signal must be converted into an electrical signal (in some cases, the electrical signal is also amplified by an amplifier). Thereafter, the phase difference is measured. In this case, phase conditions must be sufficiently taken into consideration to constitute the apparatus.

In Applied Optics, vol. 29, no 31, November 1990, New York US, pages 4578-4582, R.I. MacDonald et al, "Frequency domain optical reflectometer using a GaAs optoelectronic mixer", a frequency domain optical reflectometer which uses a GaAs interdigital photodetector both for optical detection and for mixing is described. A simple receiver with a postdetection bandwidth of the order of 10 kHz is sufficient for distance resolution of 10 m with the technique described, simplifying the electronics by comparison with pulsed reflectometers or swept frequency reflectometers employing electronic mixing. The use of lasers could enable the instrument to detect discrete optical reflections of - 57 dB at a distance of 1 km. The reflector comprises a sweep oscillator which generates a constant amplitude input signal which is swept linearly over a predetermined frequency range. This input signal is split; one branch modulates the output of a laser diode, and the other branch is used as the local oscillator bias for the photodetector. The laser diode output is transmitted to a liquid whose refractive index is to be measured, reflected and transmitted to the photodetector. Due to the frequency sweep of the input signal and the delay in transmission of the laser diode output to the photodetector via the liquid whose refractive index is to be measured, the signals input to the photodetector have different frequencies. The frequency difference is used to measure the refractive index of the liquid.

In P. Horowitz & W. Hill, "The Art of Electronics", Cambridge University Press, 1980, Cambridge, US, page 571, mixers and modulators are described. Moreover, it is stated that a circuit that forms a product of two analog waveforms may be used in a variety of radiofrequency applications and may be considered as a modulator, mixer, synchronous detector or phase detector.

In Research Disclosure, April 1985, no. 252, pages 187-189, there is described a circuit for a range finder including a oscillator which pulses or sinusoidally modulates an LED at a fixed frequency. Light emitted from the LED is reflected from the subject and sensed by a photosensor and the signal therefrom is amplified and fed into a phase detector. A similar periodic signal is also emitted by the oscillator and fed to a variable delay or phase-shifter element. The phase-detector detects the difference in phase between the signal from the variable delay and the reflected signal and emits a signal, positive or negative with respect to a reference signal, representing the phase difference between the light emitted from the LED and light received by the photosensor. The signal representing the phase difference is filtered and integrated over many cycles and fed back to a phase control input of the variable delay circuit. This feedback signal adjusts a phase-shifter control voltage which in turn adjusts the amount of delay imposed by the delay circuit until a zero resultant output is obtained from the phase detector when both input signals to the phase detector are locked in phase. Range to the subject is determined by the locked-in phase shifter control voltage. However, this disclosure also requires the optical signal to be converted into an electrical signal to measure the phase difference.

It is therefore desirable to easily and precisely obtain a phase difference between an optical signal and an electrical signal without the need of first converting the optical signal into an electrical signal.

### SUMMARY OF THE INVENTION

According to one aspect of the present invention, there is provided a phase difference detecting method comprising: applying an electrical signal having a first frequency to a photoconductive light-receiving device; applying an optical signal, modulated with said first frequency, to said photoconductive light-receiving device; generating a current by said photoconductive light-receiving device in accordance with a product of said electrical signal and said optical signal; generating a time average value of said current, or of a voltage obtained from said current upon conversion; and outputting said time average value, said time average value according to the phase difference between said electrical signal and said optical signal.

Accordingly, in the phase difference detecting method a product of an electrical signal and a light intensity-modulated signal, both of which have the same frequency, is directly operated, and the signals are then converted into a signal which reflects a phase difference.

Preferred features of the phase difference detecting method are recited in claims 2 and 3.

According to another aspect of the present invention, there is provided a phase difference detecting circuit comprising: a voltage applying unit for applying a voltage signal having a first frequency; a photoconductive light-receiving device being provided with said voltage signal and an optical signal, modulated with said first frequency, for generating a current in accordance with a product of said voltage signal and said optical signal; a time average circuit for generating and outputting a time average value of said current, or of a voltage obtained from said current upon conversion, said time average value according to the phase difference between said voltage signal and said optical signal.

Preferred features of the phase difference detecting circuit are recited in claims 5 to 9.

There is also provided a phase difference detecting apparatus having the features of claims 10 and 11.

In the phase difference detecting method, circuit, and apparatus, the voltage signal having a predetermined frequency is applied to the photoconductive light-receiving device, and the optical signal is received by this photoconductive light-receiving device. The current generated upon reception of light and flowing in the photoconductive light-receiving device reflects a product value of the applied voltage signal and the optical signal, and contains a DC component according to the phase difference between the applied voltage signal and the component of the optical signal having the same intensity modulation frequency as that of the applied voltage signal. The time average value of the current flowing in the photoconductive light-receiving device or a voltage value obtained upon conversion of this current is arithmetically operated, and only the DC component is extracted, thereby detecting the phase difference between the applied voltage signal and the component of the optical signal having the same intensity modulation frequency as that of the applied voltage signal.

According to the phase difference detecting method, circuit, and apparatus, the product of the applied voltage signal and the optical signal is directly generated by the photoconductive light-receiving device, and the value obtained upon time-averaging the generated product is measured, thereby detecting the phase difference. Therefore, the phase difference between the optical signal and the electrical signal can be easily and precisely detected.

In addition, when the phase difference detecting method, circuit, and apparatus of the present invention are applied to an optical distance measuring instrument, a high-frequency amplifier which is difficult to handle need not be used. Since a decrease in distance measurement accuracy due to sneak of a high-frequency signal can be prevented, distance measurement can be performed with high accuracy.

The present invention will become more fully understood from the detailed description given hereinbelow and the accompanying drawings which are given by way of illustration only, and thus are not to be considered as limiting the present invention.

### BRIEF DESCRIPTION OF THE DRAWINGS

Fig. 1 is a diagram showing the basic arrangement of an embodiment of the present invention;
Figs. 2 and 3 are charts for explaining a first embodiment (rectangular wave input) of a phase difference detecting method;
Figs. 4 and 5 are charts for explaining a second embodiment (sine wave input) of the phase difference detecting method;
Figs. 6 and 7 are charts for explaining applied voltage signals;
Fig. 8 is a diagram showing a first arrangement of a phase difference detecting circuit;
Figs. 9 to 11 are graphs for explaining the characteristics of a photoconductive light-receiving device;
Fig. 12 is a diagram showing a second arrangement of the phase difference detecting circuit.
Fig. 13 is a diagram showing a third arrangement of the phase difference detecting circuit;
Fig. 14 is a diagram showing a fourth arrangement of the phase difference detecting circuit;
Fig.15 is a diagram showing a fifth arrangement of the phase difference detecting circuit;
Fig. 16 is a diagram showing a sixth arrangement of the phase difference detecting circuit;
Fig. 17 is a diagram showing an embodiment of a phase difference detecting apparatus;
Fig. 18 is a chart for explaining a normalized phase difference signal upon reception of a rectangular wave;
Fig. 19 is a chart for explaining the generation of an interval signal upon reception of the rectangular wave;
Fig. 20 is a chart for explaining a phase difference output;
Fig. 21 is a chart for explaining a normalized signal upon reception of a sine wave; and
Fig. 22 is a chart for explaining the generation of the interval signal upon reception of the sine wave.

### DETAILED DESCRIPTION OF THE EMBODIMENTS

Embodiments of the present invention will be described below with reference to the accompanying drawings. The same reference numerals and symbols throughout the drawings denote the same elements, and a detailed description thereof will be omitted.

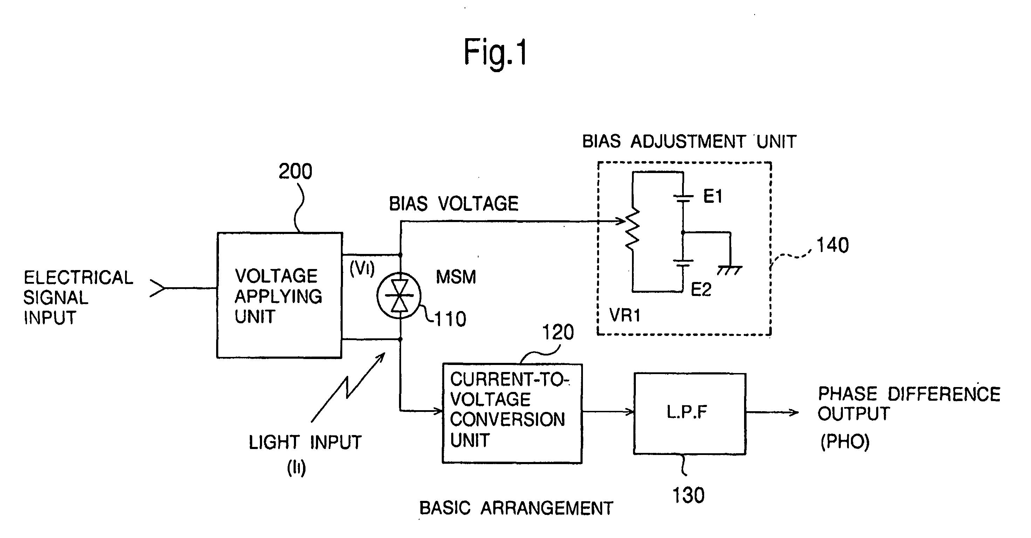

Fig. 1 is a diagram showing the basic arrangement of the main part of a phase difference detecting apparatus. As shown in Fig. 1, the main part of this apparatus is constituted by a photoconductive light-receiving device 110, a voltage applying unit 200, a current-to-voltage conversion unit 120, a low-pass filter (LPF) 130, and a bias adjustment unit 140. The voltage applying unit 200 applies a voltage according to an input electrical signal to the photoconductive light-receiving device 110. The current-to-voltage conversion unit 120 receives the current flowing in the photoconductive light-receiving device 110 which was generated in accordance with the applied voltage and the light-receiving amount and converts the current value into a voltage value. The low-pass filter 130 generates the time average of the voltage signal output from the current-to-voltage conversion unit 120 and outputs a DC component value. The bias adjustment unit 140 sets the operation of the photoconductive light-receiving device 110 such that an output current value becomes zero with respect to DC incident light such as background light.

As the photoconductive light-receiving device 110, a metal-semiconductor-metal (MSM) photodetector or the like is used. In this photodetector, an amount of current flowing in the photoconductive light-receiving device represents a substantially odd function of the applied voltage.

An embodiment of a phase difference detecting method will be described below with reference to Fig. 1. (First Embodiment of Phase Difference Detecting Method (both signals are rectangular wave signals having the same period.))

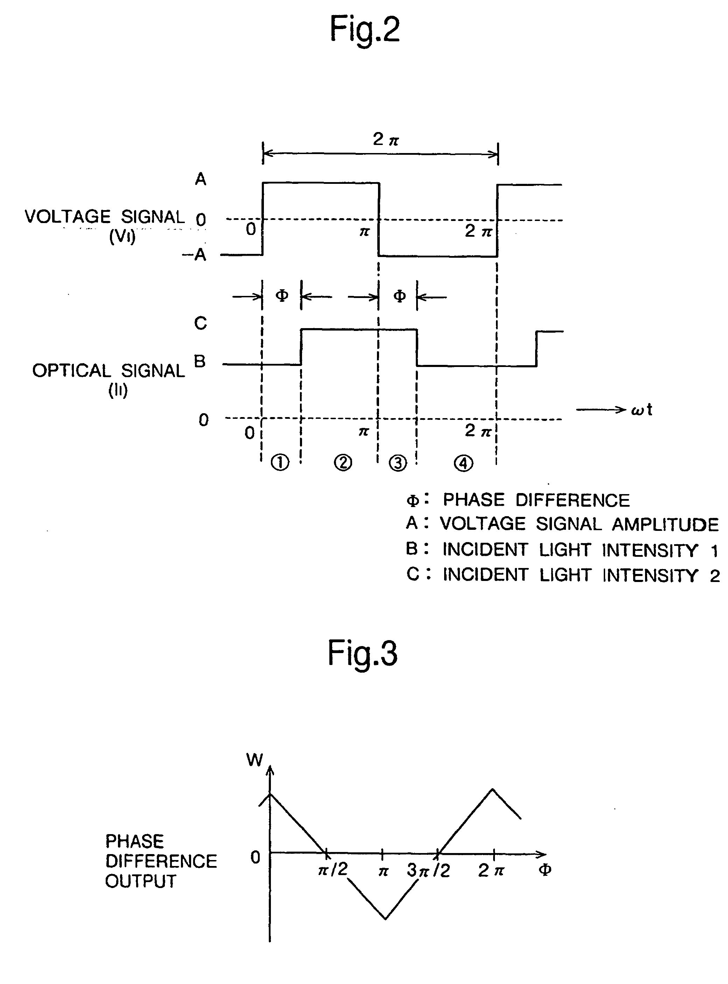

Figs. 2 and 3 are explanatory charts of this embodiment. Fig. 2 is a chart showing input signals (i.e., an applied voltage signal (V_{I}) and an optical signal (I_{I}) of the intensity) to the photoconductive light-receiving device 110 in this embodiment. As shown in Fig. 2, the signals V_{I} and I_{I} are periodic. Within one period (0 < ωt < 2π), when a phase difference satisfies Φ ≤ π, the signals V_{I} and I_{I} are represented by the following equations. 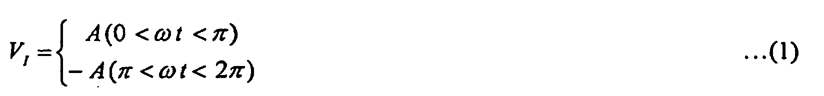 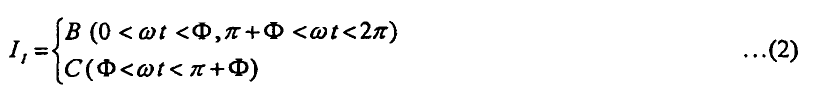 where
- A:: voltage signal amplitude
- B:: incident light intensity 1
- C:: incident light intensity 2

The photoconductuive light-receiving device 110 generates a current according to a product value of the signals V_{I} and I_{I} at each time. Assume that one period is divided into intervals ① to ④ as in Fig. 2. In this case, output voltage values to W4 from the current-to-voltage conversion unit 120 in these intervals are represented as follows.$\text{W1 = K1 * K2 * K3 * A * B}$$\text{W2 = K1 * K2 * K3 * A * C}$$\text{W3 = -K1 * K2 * K3 * A * C}$$\text{W4 = -K1 * K2 * K3 * A * B}$ where
- K1:: proportional constant of the output current with respect to the voltage applied to the photoconductive light-receiving device
- K2:: proportional constant of the output current with respect to the input light intensity of the photoconductive light-receiving device
- K3:: conversion constant of the current-to-voltage conversion unit.

Therefore, a phase difference output (PHO) value W from the low-pass filter 130 is represented as follows. 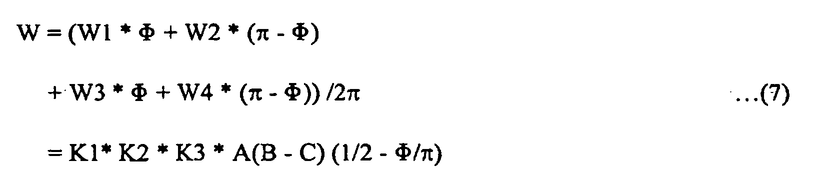 Similarly, when the phase difference is π < Φ < 2π, the value W is represented as follows.$\text{W = K1 * K2 * K3 * A(B - C) (Φ/π - 3/2)}$ That is, the phase difference output (PHO) value W polygonally changes with respect to the phase difference Φ, and becomes zero when Φ = π/2 or Φ = 3π/2 (Fig. 3). Therefore, when the phase diffierence Φ is set to change within a range of 2nπ ≤ Φ ≤ (2n + 1) π or (2n - 1)π ≤ Φ ≤ 2nπ (n: integer), the phase difference can be detected from the phase difference output (PHO) value W.

### (Second Embodiment of Phase Difference Detecting Method (both signals are sine wave signals having the same period.))

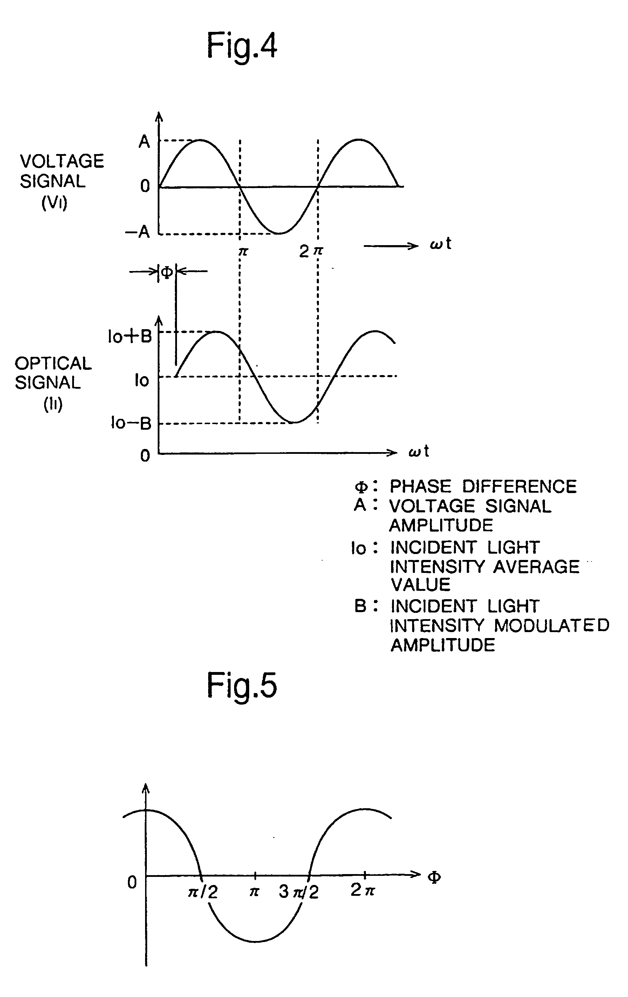

Figs. 4 and 5 are explanatory charts of the second embodiment. Fig. 4 is a chart showing input signals (i.e., an applied voltage signal (V_{I}) and an optical signal (I_{I})) to a photoconductive light-receiving device 110 in this embodiment. As shown in Fig. 4, the signals V_{I} and I_{I} are periodic. Within one period (0 < ωt < 2π), when a phase difference satisfies Φ ≤ n, the signals V_{I} and I_{I} are represented by the following equations.${\text{V}}_{\text{I}} \text{= A * sinωt}$${\text{I}}_{\text{I}} {\text{= B * sin(ωt - Φ) + I}}_{\text{0}}$ where ω: angular frequency

As in the above first embodiment, the photoconductive light-receiving device 110 generates a current according to a product value of the signals V_{I} and I_{I} at each time. An output voltage value w from a current-to-voltage conversion unit 120 at each time is represented as follows.$\text{w} \text{=} \text{K} \text{1*} \text{K} \text{2*} \text{K} \text{3*} {\text{V}}_{\text{I}} \text{*} {\text{I}}_{\text{I}} \text{=} \text{K} \text{1 *} \text{K} \text{2 *} \text{K} \text{3 *} \text{A} \text{(} \text{B} \text{sin ω} \text{t} \text{* sin (} \text{ωt} \text{- Φ)+} {\text{I}}_{\text{o}} \text{sin ω} \text{t} \text{)}$ Therefore, a phase difference output (PHO) value W from a low-pass filter 130 is represented by the following equation. 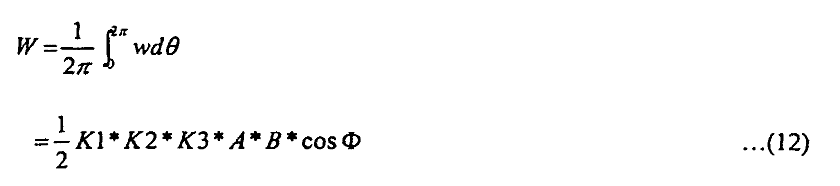 where θ = ωt. That is, the phase difference output (PHO) value W changes along a cosine curve with respect to the phase difference Φ and becomes zero when Φ = π/2 or Φ = 3π/2 (Fig. 5). When the phase difference Φ is set to change within a range of 2nπ ≤ Φ ≤ (2n + 1)π (n: integer) or (2n - 1) π ≤ Φ ≤ 2nπ (n: integer), the phase difference can be detected from the phase difference output (PHO) value W.

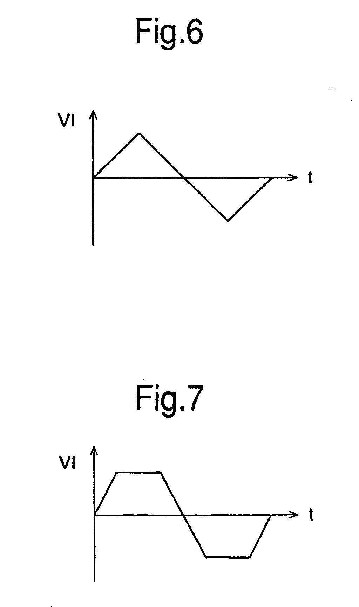

The typical embodiments of the phase detecting method have been described above. The waveforms of the applied voltage and optical signals subjected to the phase difference detection are not limited to the above-described rectangular or sine wave. As long as it is a periodic signal having a time average value of almost zero, and its amplitude represents an even function of time when the origin is set at an intermediate point between the adjacent times where the amplitude becomes zero, the phase detecting method can be performed. For example, a triangular wave shown in Fig. 6, or a trapezoidal wave shown in Fig. 7 can also be used. The applied voltage and optical signals need not have a waveform of the same type. As long as both the signals have the same period and a time average value of almost zero, and their amplitudes represent an even function of time when the origin is set at an intermediate point between the adjacent times where the amplitude becomes zero, the phase detecting method can be performed.

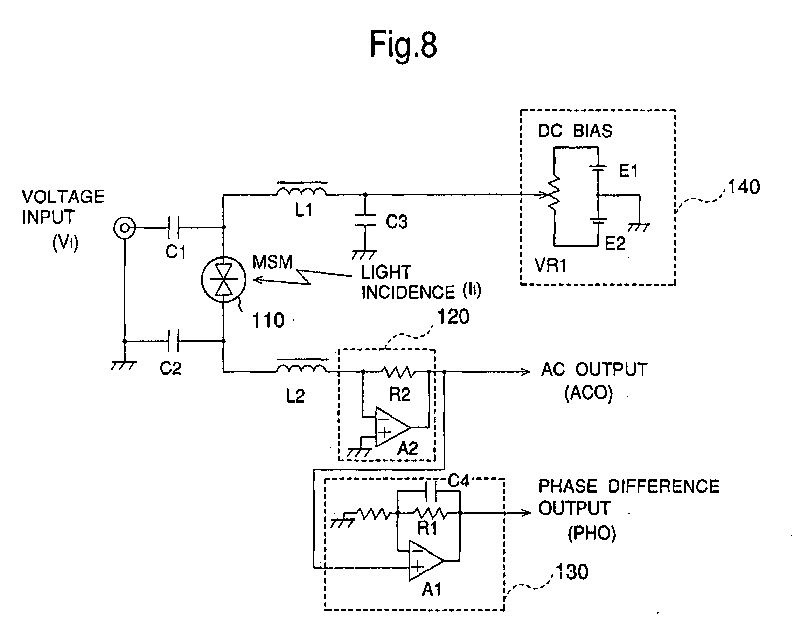

An embodiment of a phase difference circuit for realizing the above phase difference detecting method will be described below. Fig. 8 is a diagram showing the first arrangement of a phase difference detecting circuit. This phase difference detecting circuit is constituted by a photoconductive light-receiving device 110, connection capacitors C1 and C2, choke coils L1 and L2, a current-to-voltage conversion unit 120, a low-pass filter 130, and a bias adjustment circuit 140. The photoconductive light-receiving device 110 receives an optical signal (I_{I}) and an applied voltage signal (V_{I}) to arithmetically operate a product of the optical and voltage signals, thereby outputting a current signal which reflects the phase difference between reflected modulated light and a modulated signal. The connection capacitors C1 and C2 apply the voltage signal of the AC component of the voltage signal to the photoconductive light-receiving device 110. The choke coils L1 and L2 pass the current signal generated in the photoconductive light-receiving device 110. The current-to-voltage conversion unit 120 converts the AC component of the current signal flowing in the photoconductive light-receiving device 110 and the choke coils L1 and L2 into a voltage. The low-pass filter 130 arithmetically operates and outputs the time average of the voltage signal output from the current-to-voltage conversion unit 120. The bias adjustment circuit 140 adjusts the bias value of the voltage applied to the photoconductive light-receiving device 110.

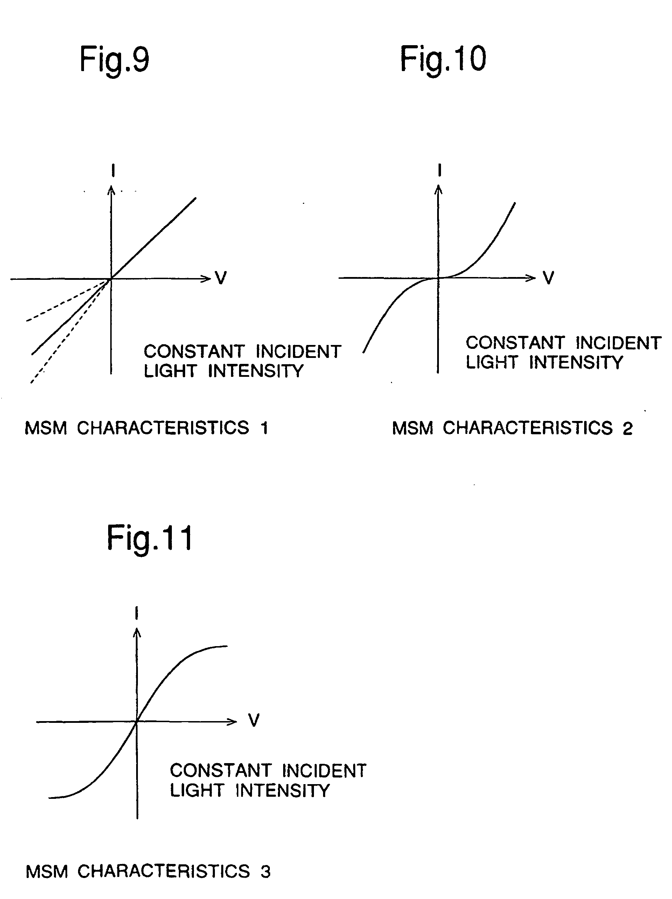

The photoconductive light-receiving device 110 is constituted by a metal-semiconductor-metal (MSM) sensor consisting of GaAs. Assume that the incident light intensity is constant and the applied voltage signal value is an independent variable. In this case, the photoconductive light-receiving device 110 has characteristics in which a current amount flowing in the photoconductive light-receiving device represents an odd function of the applied voltage signal within a predetermined range including an applied voltage signal value of O V. Figs. 9 to 11 are graphs exemplifying the characteristics of the photoconductive light-receiving device which can be applied to the phase difference detecting circuit of this embodiment.

The current-to-voltage conversion unit 120 is constituted by an operational amplifier A2 and a resistor R2. An input AC current signal is converted into a voltage by the resistor R2, and a voltage signal is output.

The low-pass filter 130 is constituted by an operational amplifier A1, a capacitor C4, and a resistor R1. The low-pass filter 130 integrates the input voltage signal by a time constant defined by a product of the capacitance of the capacitor C4 and the resistance of the resistor R1 to arithmetically operate the time average value, thereby outputting a substantially DC voltage according to the phase difference.

The bias adjustment circuit 140 is constituted by a variable resistor VR1 for adjusting a bias voltage value and DC power supplies E1 and E2 which are connected to the terminals of the variable resistor VR1 and also connected in series with each other. The connecting point between the DC power supplies E1 and E2 is set to the ground potential.

In the circuit of this embodiment, the AC component of the voltage signal input from the voltage applying unit 200 is applied to the photoconductive light-receiving device 110. When an optical signal is incident on the photoconductive light-receiving device 110 to which the voltage signal is applied, a current according to the product value of the applied voltage signal and optical signals flows in the photoconductive light-receiving device 110. This current signal is input to the current-to-voltage conversion unit 120 through the choke coil L2, converted into a voltage signal (ACO), and output. This voltage signal contains an AC component which has not been completely removed by the choke coils L1 and L2. The low-pass filter receives the voltage signal and arithmetically operates the time average, thereby outputting a DC voltage (PHO). This DC voltage value coincides with the phase difference output (PHO) value W in the above phase difference detecting method. By the bias adjustment circuit 140, the phase difference output value is set to become "O V" upon incidence of DC light such as background light. In this case, even if the current characteristic of the photoconductive light-receiving device 110 with respect to the applied voltage signal does not represent an odd function characteristic, as indicated by a broken line in Fig. 9, an output value of "O V" can be obtained in the phase difference of Φ = π/2 or 3π/2.

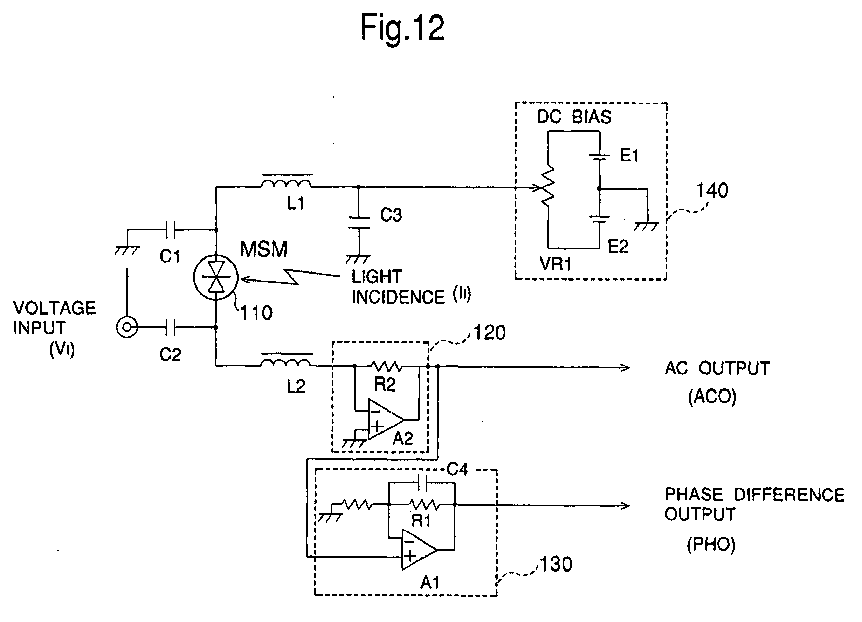

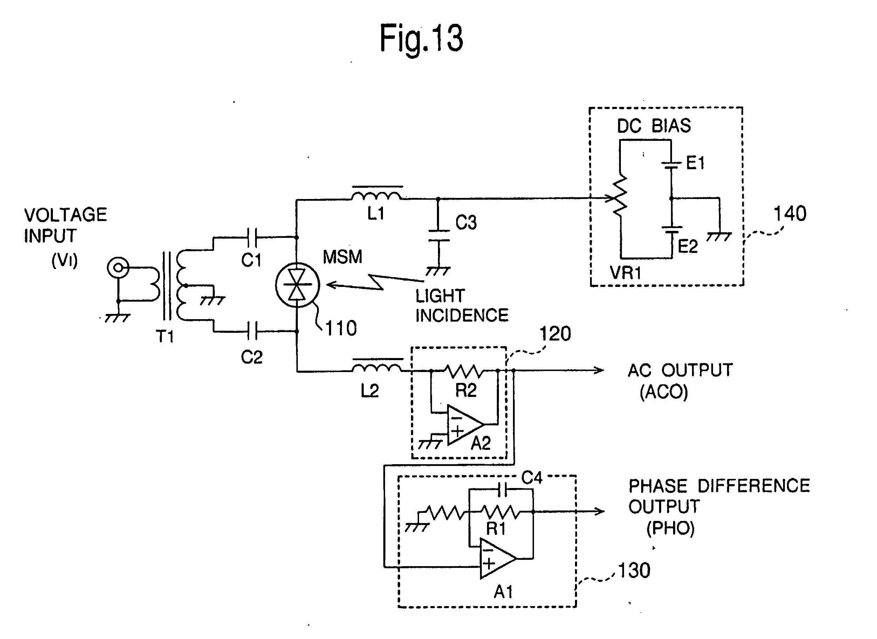

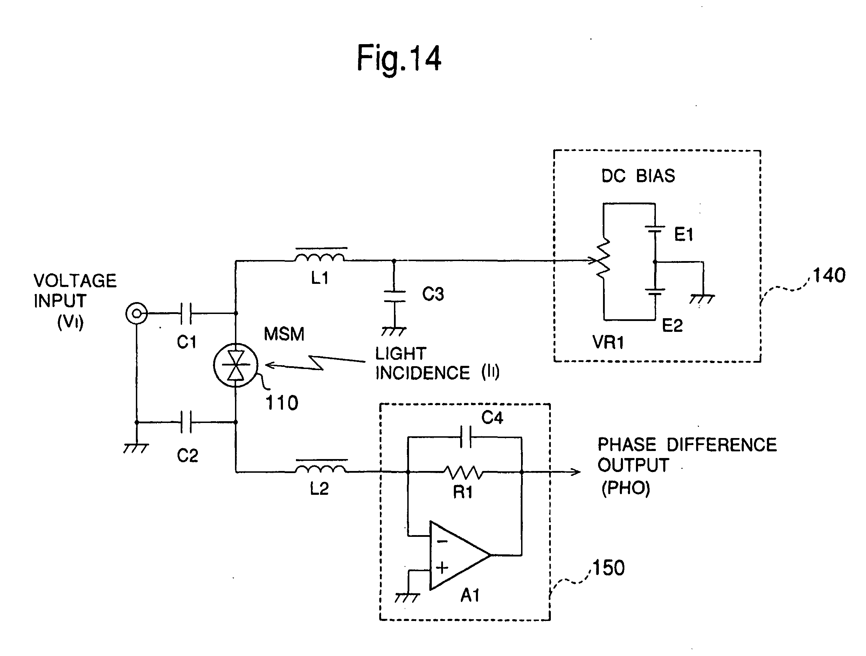

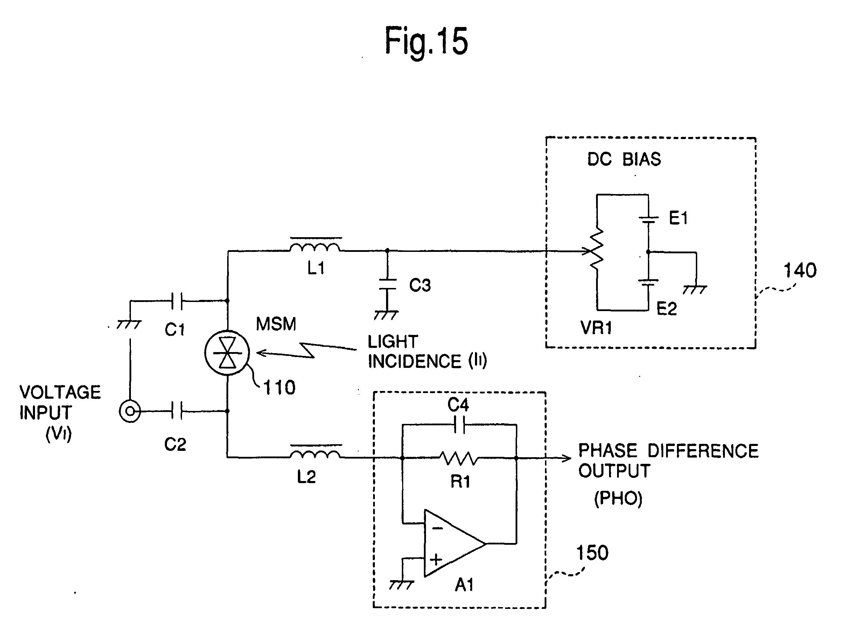

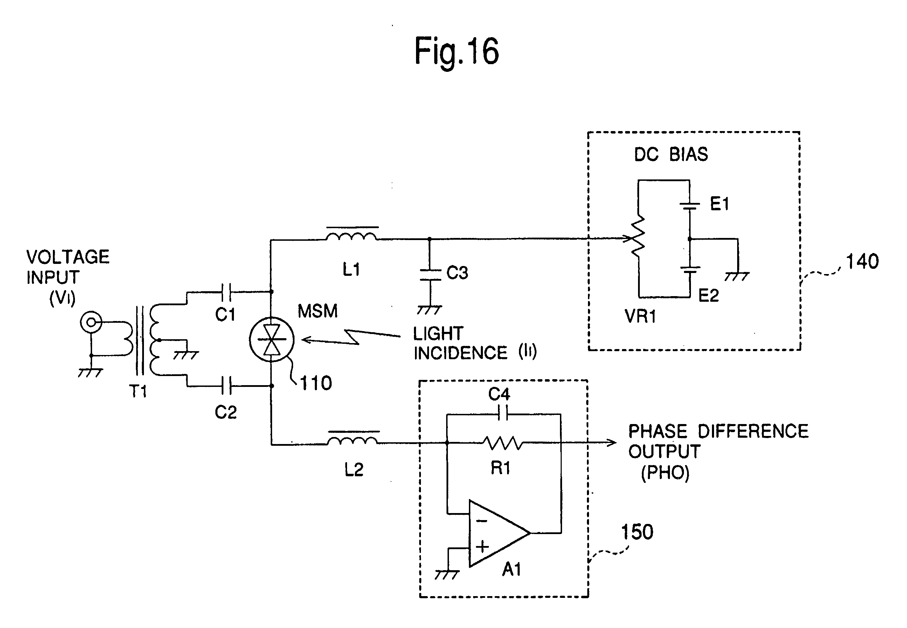

Even when the voltage signal applying method of the arrangement in Fig. 8 is changed to the second arrangement of the phase difference detecting circuit shown in Fig. 12 or the third arrangement of the phase difference circuit shown in Fig. 13, a DC voltage output according to the phase difference can also be obtained. As shown in Figs. 14 to 16, even when the current-to-voltage conversion unit 120 and the low-pass filter 130 in Figs. 8, 12, and 13 are integrally formed and replaced with a filter 150, a DC voltage output according to the phase difference can be obtained.

An embodiment of a phase difference detecting apparatus using the above phase difference detecting circuit will be described below.

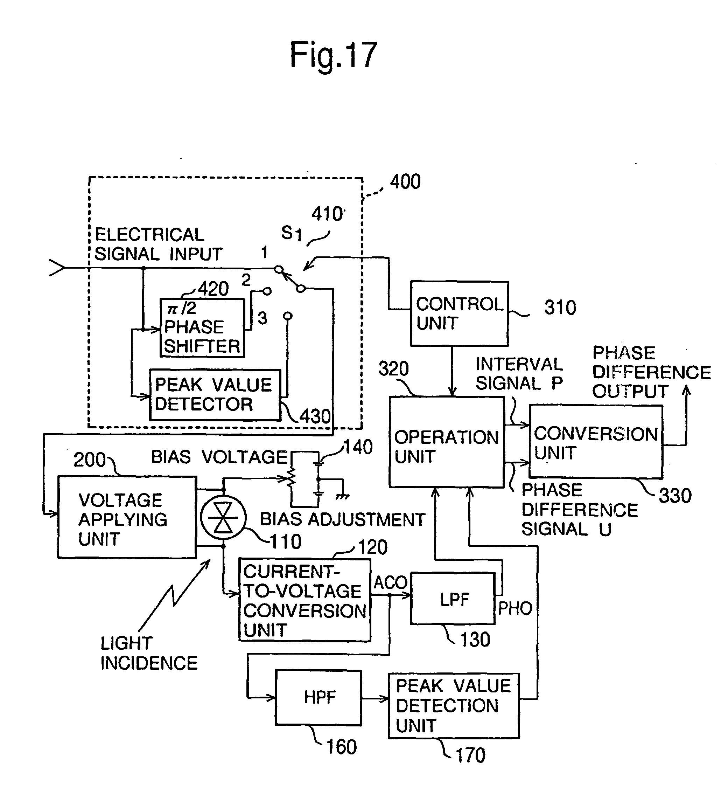

Fig. 17 is a diagram showing an embodiment of a phase difference apparatus. The apparatus of this embodiment uses the phase difference detecting circuit in Fig. 8, 12, or 13. As shown in Fig. 17, this apparatus is constituted by, in addition to the basic arrangement shown in Fig. 1, (a) a signal selection unit 400, (b) a high pass filter (HPF) 160, (c) a peak value detection unit 170, (d) a control unit 310, (e) an operation unit 320, and (f) a conversion unit 330. The signal selection unit 400 selects a signal to be input to a voltage applying unit 200. The high-pass filter 160 receives the signal output from the AC output terminal (ACO) of a current-to-voltage conversion unit 120 and outputs a signal after removal of a DC component. The peak value detection unit 170 receives the signal output from the high-pass filter 160 to measure a peak value. The control unit 310 performs selection designation to the signal selection unit 400. The operation unit 320 receives output signals from a low-pass filter 130 and the peak value detection value detection unit 170 and outputs a normalized phase difference signal and an interval signal indicating the interval of a phase difference in accordance with selection designation from the control unit 310. The conversion unit 330 receives the nonnalized phase difference signal and the interval signal, converts these signals into a phase difference value, and outputs the phase difference signal unique to the phase difference.

The signal selection unit 400 is constituted by ① a phase shifter 420, ② a peak value detector 430, and ③ a switch 410. The phase shifter 420 shifts the phase of an input electrical signal by π/2. The peak value detector 430 measures the peak value of the input electrical signal. The switch 410 selects one of the input electrical signal (selection 1), an output signal from the phase shifter 420 (selection 2), and an output signal from the peak value detector 430 (selection 3) in accordance with selection designation from the control unit 310 and supplies the selected signal to the voltage applying unit 200.

A phase detection operation is performed by this apparatus as follows.

### [Rectangular Wave Input (Figs. 2 and 3)]

First of all, the control unit 310 notifies selection designation of selection 3 to the switch 410 and the operation unit 320. In this setting, an output value V from the high-pass filter 160 is represented by the following equation.$\text{V =} \text{(1/2)} \text{-K1 -K2 -K3 -A} \text{(} \text{C - B} \text{)}$ The value V is the maximum value of the value W represented by equation (7) or (8). The operation unit 320 receives and stores this value V.

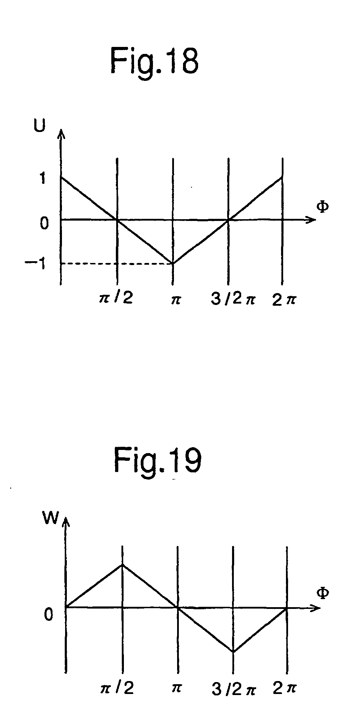

The control unit 310 then notifies selection designation of selection 1 to the switch 410 and the operation unit 320. In this setting, an output value from the low-pass filter 130 is the value W represented by equation (7) or (8). The operation unit 320 receives the value W and divides the value W by the value V to output a normalized phase difference signal U. Fig 18 is a graph showing a change in phase difference signal U with respect to a phase difference Φ. The phase difference signal U does not depend on the amplitude value of a voltage signal and the intensity value of an optical signal input to the photoconductive light-receiving device 110. For this reason, by using the phase difference signal U, the phase difference can be detected regardless of the amplitude value of the applied voltage signal and the intensity value of the optical signal input to the photoconductive light-receiving device 110.

As described above, when the phase difference changes within a_range of 0 to π or π to 2π, a phase difference can be obtained uniquely from the value of the phase difference signal U.

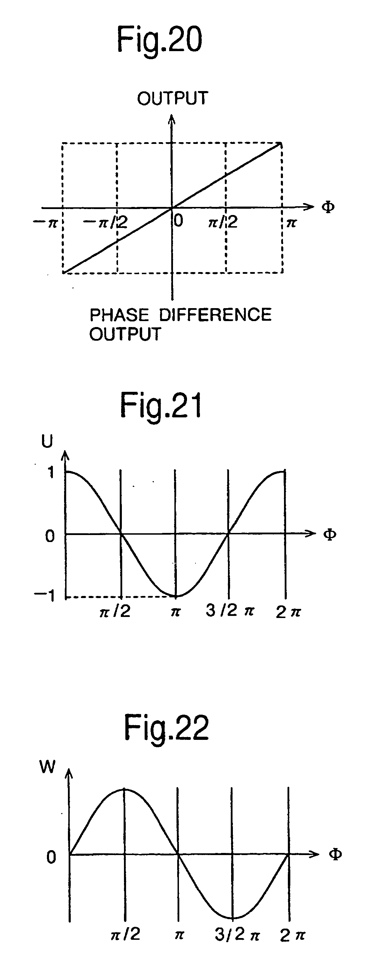

However, when the phase difference changes within a range of 0 to 2π, two phase difference values can be obtained as candidates for one phase difference signal U. For this reason, a phase difference cannot be determined uniquely by only the above measurement operation. In this case, after the above measurement operation, the control unit 310 notifies selection designation of selection 2 to the switch 410 and the operation unit 320. In this setting, an output value from the low-pass filter 130 is obtained by replacing Φ in the value W represented by equation (7) or (8) with (Φ + π/2), as shown in a graph in Fig. 19. As is apparent from this graph, in a phase difference range of 0 to n, the value W becomes positive. In a phase difference range of π to 2π, the value W becomes negative. The operation unit 320 receives the value W and outputs the positive/negative state of the value W as an interval signal. The conversion unit 330 receives this positive/negative information and the phase difference signal U, converts them into a unique phase difference value, and outputs a phase difference output signal as shown in Fig. 20. Note that generation of an interval signal and the operation of the conversion unit 330 can also be applied even when the phase difference changes within a range of 0 to π or π to 2π.

### [Sine Wave Input (Figs. 4 and 5)]

In the apparatus of this embodiment, a phase difference can also be detected upon reception of a sine wave in the same manner as in reception of a rectangular wave.

The control unit 310 notifies selection designation of selection 3 to the switch 410 and the operation unit 320. In this setting, the output value V from the high-pass filter 160 is represented by the following equation.$\text{V} \text{=(1/2) *} \text{K} \text{1} \text{* K} \text{2} \text{* K} \text{3 *} \text{A} \text{*} \text{B}$ The value V is the maximum value of the value W represented by equation (12). The operation unit 320 receives and stores this value V.

The control unit 310 notifies selection designation of selection 1 to the switch 410 and the operation unit 320. In this setting, an output value from the low-pass filter 130 is the value W represented by equation (12). The operation unit 320 receives the value W and divides the value W by the value V to output the normalized phase difference signal U. Fig. 21 is a graph showing a change in phase difference signal U with respect to the phase difference Φ. The phase difference signal U does not depend on the amplitude value of a voltage signal and the intensity value of an optical signal input to the photoconductive light-receiving device 110. For this reason, by using the phase difference signal U, the phase difference can be detected regardless of the amplitude value of the applied voltage signal and the intensity value of the optical signal input to the photoconductive light-receiving device 110.

As described above, when the phase difference changes within a range of 0 to π or π to 2π, the phase difference can be obtained uniquely from the value of the phase difference signal U.

However, when the phase difference changes within a range of 0 to 2π, as is apparent from Fig. 21, two phase difference values can be obtained for one phase difference signal U. For this reason, the phase difference cannot be determined uniquely by only the above measurement operation. In this case, after the above measurement operation, the control unit 310 notifies selection designation of selection 2 to the switch 410 and the operation unit 320. In this setting, an output value from the low-pass filter 130 is obtained by replacing Φ in the value W represented by equation (12) with (Φ + π/2), as shown in a graph in Fig. 22. As is apparent from this graph, in a phase difference range of 0 to π, the value W becomes positive. In a phase difference range of π to 2π, the value W becomes negative. The operation unit 320 receives the value W and outputs the positive/negative state of the value W as an interval signal. The conversion unit 330 receives the positive/negative information and the phase difference signal U, converts them into a unique phase difference value, and outputs a phase difference output signal as shown in Fig. 20. When a sine wave is input, as in reception of a rectangular wave, generation of an interval signal and the operation of the conversion unit 330 can be applied even when the phase difference changes within a range of 0 to π or π to 2π.

According to the apparatus of this embodiment, an input wave is not limited to the rectangular or sine wave. Even when a triangular or trapezoidal wave as shown in Fig. 6 and Fig. 7 is input, the phase difference can also be detected.

The present invention is not limited to the above embodiments, and various changes and modification can be made. The above embodiments exemplify an MSM light receiving device consisting of a GaAs material as the photoconductive light-receiving element. However, various materials (e.g., monocrystalline silicon, InP, and amorphous silicon) as proposed in "Yoshida et al.: High-Speed Silicon Switch, Applied physics, Vol. 50, No. 5, pp. 489-495" can also be used. In addition, although not adequate to a highspeed operation, a CdS cell can also be used.

Thus, various modifications and variations to the above described embodiments could be made without falling outside the scope of the present invention as determined from the claims.

## Claims

1. A phase difference detecting method comprising:
applying an electrical signal having a first frequency to a photoconductive light-receiving device;
applying an optical signal, modulated with said first frequency, to said photoconductive light-receiving device;
generating a current by said photoconductive light-receiving device in accordance with a product of said electrical signal and said optical signal;
generating a time average value of said current, or of a voltage obtained from said current upon conversion; and
outputting said time average value, said time average value according to the phase difference between said electrical signal and said optical signal.

2. A method according to claim 1, further comprising:
converting the value of the current generated by said photoconductive light-receiving device into a voltage value.

3. A method according to claim 1, wherein in said photoconductive light-receiving device, provided that the intensity of incident light is made constant and an input voltage is varied independently, the amount of current generated by said photoconductive light-receiving device represents a substantially odd function of the applied input voltage including 0V, and provided that the input voltage is made constant and the incident light intensity is varied independently, the amount of current generated by said photoconductive light-receiving device represents a substantially linear function of the incident light intensity within a predetermined range of the incident light intensity, and
the electrical signal applied to said photoconductive light-receiving device is a periodic signal having a time average of almost zero, and an amplitude of the electrical signal represents an even function of time when the origin is set at a central point between adjacent times where the amplitude becomes zero.

4. A phase difference detecting circuit comprising:
a voltage applying unit (200) for applying a voltage signal having a first frequency;
a photoconductive light-receiving device (110) being provided with said voltage signal and an optical signal modulated with said first frequency, for generating a current in accordance with a product of said voltage signal and said optical signal;
a time average circuit (130) for generating and outputting a time average value of said current, or of a voltage obtained from said current upon conversion, said time average value according to the phase difference between said voltage signal and said optical signal.

5. A phase difference detecting circuit of claim 4, comprising:
a current-to-voltage conversion unit (120) for converting the current generated by the photoconductive light-receiving device (110) into a voltage.

6. A phase difference detecting circuit of claim 4, further comprising a bias adjustment circuit (140) for adjusting an operating bias voltage to said photoconductive light receiving device (110).

7. A phase difference detecting circuit of claim 4, wherein, in said photoconductive light-receiving device (110), provided that the intensity of incident light is constant and an input voltage is an independent variable, the amount of current generated by said photoconductive light-receiving device (110) represents a substantially odd function of the input voltage within a predetermined range of the input voltage including 0V, and provided that the input voltage is constant and the incident light intensity is an independent variable, the amount of current generated by said photoconductive light-receiving device (110) represents a substantially linear function of the incident light intensity within a predetermined range of the incident light intensity.

8. A phase difference detecting circuit according to claim 7, wherein said photoconductive light-receiving device (110) is a photodetector having a metal-semiconductor-metal structure.

9. A phase difference detecting circuit according to claim 5, wherein said time averaging circuit (130) comprises a voltage averaging circuit for receiving the voltage output from said current-to-voltage conversion unit (120) to generate a time average value thereof.

10. A phase difference detecting apparatus comprising a phase difference detecting circuit according to claim 4, wherein said voltage applying unit (200) is arranged to receive an electrical signal having said first frequency to apply said voltage signal to said photoconductive light-receiving device (110).

11. A phase difference detecting apparatus according to claim 10, wherein, in said photoconductive light-receiving device (110), provided that the intensity of incident light is constant and an input voltage is an independent variable, the amount of current generated by said photoconductive light-receiving device (110) represents a substantially odd function of the input voltage within a predetermined range of the input voltage including 0V, and provided that the input voltage is constant and the incident light intensity is an independent variable, the amount of current generated by said photoconductive light-receiving device (110) represents a substantially linear function of the incident light intensity within a predetermined range of the incident light intensity, and
the voltage signal applied by said voltage applying unit (200) is a periodic signal having a time average of almost zero, and the amplitude of the voltage signal represents an even function of time when the origin is set at a central point between adjacent times where the amplitude becomes zero.

## Patentansprüche

1. Phasendifferenzerfassungsverfahren, das folgendes umfaßt:
Anlegen eines elektrischen Signals mit einer ersten Frequenz an eine fotoleitfähige Lichtempfangseinrichtung,
Anlegen eines mit der ersten Frequenz modulierten optischen Signals an die fotoleitfähige Lichtempfangseinrichtung,
Erzeugen eines Stroms durch die fotoleitfähige Lichtempfangseinrichtung entsprechend einem Produkt aus dem elektrischen Signal und dem optischen Signal,
Erzeugen eines zeitlichen Mittelwerts des Stroms oder einer nach Umwandlung aus dem Strom erhaltenen Spannung und
Ausgeben des zeitlichen Mittelwerts, wobei dieser der Phasendifferenz zwischen dem elektrischen Signal und dem optischen Signal entspricht.

2. Verfahren nach Anspruch 1, das weiterhin folgendes umfaßt:
Umwandeln des Wertes des durch die fotoleitfähige Lichtempfangseinrichtung erzeugten Stroms in einen Spannungswert.

3. Verfahren nach Anspruch 1, bei dem bei der fotoleitfähigen Lichtempfangseinrichtung unter der Voraussetzung, daß die einfallende Lichtstärke konstant gehalten und eine Eingangsspannung unabhängig variiert wird, die Menge des durch die fotoleitfähige Lichtempfangseinrichtung erzeugten Stroms eine im wesentlichen ungerade Funktion der angelegten Eingangsspannung einschließlich 0 V darstellt und unter der Voraussetzung, daß die Eingangsspannung konstant gehalten und die einfallende Lichtstärke unabhängig variiert wird, die Menge des durch die fotoleitfähige Lichtempfangseinrichtung erzeugten Stroms eine im wesentlichen lineare Funktion der einfallenden Lichtstärke innerhalb eines vorbestimmten Bereichs der einfallenden Lichtstärke darstellt und
das an die fotoleitfähige Lichtempfangseinrichtung angelegte elektrische Signal ein periodisches Signal mit einem zeitlichen Mittelwert von fast Null ist und eine Amplitude des elektrischen Signals eine gerade Funktion der Zeit darstellt, wenn der Anfangspunkt an einen Mittelpunkt zwischen nebeneinanderliegenden Zeitpunkten gesetzt wird, wo die Amplitude Null wird.

4. Phasendifferenzerfassungsschaltung, die folgendes umfaßt:
eine Spannung anlegende Einheit (200) für das Anlegen eines Spannungssignals mit einer ersten Frequenz,
eine fotoleitfähige Lichtempfangseinrichtung (110), die mit dem Spannungssignal und einem mit der ersten Frequenz modulierten optischen Signal versorgt wird, für das Erzeugen eines Stroms entsprechend einem Produkt aus dem Spannungssignal und dem optischen Signal,
eine Zeitmittelwertschaltung (130) für das Erzeugen und Ausgeben eines zeitlichen Mittelwerts des Stroms oder einer nach Umwandlung aus dem Strom erhaltenen Spannung, wobei der zeitliche Mittelwert der Phasendifferenz zwischen dem Spannungssignal und dem optischen Signal entspricht.

5. Phasendifferenzerfassungsschaltung nach Anspruch 4, die folgendes umfaßt:
eine Strom-Spannungs-Umwandlungseinheit (120) für das Umwandeln des von der fotoleitfähigen Lichtempfangseinrichtung (110) erzeugten Stroms in eine Spannung.

6. Phasendifferenzerfassungsschaltung nach Anspruch 4, die weiterhin eine Vorspannungsregelschaltung (140) für das Regeln einer Betriebsvorspannung zur fotoleitfähigen Lichtempfangseinrichtung (110) umfaßt.

7. Phasendifferenzerfassungsschaltung nach Anspruch 4, bei der bei der fotoleitfähigen Lichtempfangseinrichtung (110) unter der Voraussetzung, daß die einfallende Lichtstärke konstant und eine Eingangsspannung eine unabhängige Variable ist, die Menge des durch die fotoleitfähige Lichtempfangseinrichtung (110) erzeugten Stroms eine im wesentlichen ungerade Funktion der Eingangsspannung in einem vorbestimmten Bereich einschließlich 0 V darstellt und unter der Voraussetzung, daß die Eingangsspannung konstant und die einfallende Lichtstärke eine unabhängige Variable ist, die Menge des durch die fotoleitfähige Lichtempfangseinrichtung (110) erzeugten Stroms eine im wesentlichen lineare Funktion der einfallenden Lichtstärke innerhalb eines vorbestimmten Bereichs der einfallenden Lichtstärke darstellt.

8. Phasendifferenzerfassungsschaltung nach Anspruch 7, bei der die fotoleitfähige Lichtempfangseinrichtung (110) ein Fotodetektor mit einer Metall-Halbleiter-Metall-Struktur ist.

9. Phasendifferenzerfassungsschaltung nach Anspruch 5, bei der die Zeitmittelwertschaltung (130) eine Spannungsmittelwertschaltung umfaßt, die die von der Strom-Spannungs-Umwandlungseinheit (120) ausgegebene Spannung empfängt und einen zeitlichen Mittelwert davon erzeugt.

10. Phasendifferenzerfassungsvorrichtung, die eine Phasendifferenzerfassungsschaltung nach Anspruch 4 umfaßt und bei der die Spannung anlegende Einheit (200) angeordnet ist, um ein elektrisches Signal mit der ersten Frequenz zu empfangen und das Spannungssignal an die fotoleitfähige Lichtempfangseinrichtung (110) anzulegen.

11. Phasendifferenzerfassungsvorrichtung nach Anspruch 10, bei der bei der fotoleitfähigen Lichtempfangseinrichtung (110) unter der Voraussetzung, daß die einfallende Lichtstärke konstant und eine Eingangsspannung eine unabhängige Variable ist, die Menge des durch die fotoleitfähige Lichtempfangseinrichtung (110) erzeugten Stroms eine im wesentlichen ungerade Funktion der Eingangsspannung in einem vorbestimmten Bereich einschließlich 0 V darstellt und unter der Voraussetzung, daß die Eingangsspannung konstant und die einfallende Lichtstärke eine unabhängige Variable ist, die Menge des durch die fotoleitfähige Lichtempfangseinrichtung (110) erzeugten Stroms eine im wesentlichen lineare Funktion der einfallenden Lichtstärke innerhalb eines vorbestimmten Bereichs der einfallenden Lichtstärke darstellt und
das durch die Spannung anlegende Einheit (200) angelegte Spannungssignal ein periodisches Signal mit einem zeitlichen Mittelwert von fast Null ist und die Amplitude des Spannungssignals eine gerade Funktion der Zeit darstellt, wenn der Anfangspunkt an einen Mittelpunkt zwischen nebeneinanderliegenden Zeitpunkten gesetzt wird, wo die Amplitude Null wird.

## Revendications

1. Procédé de détection de différence de phase comprenant :
l'application d'un signal électrique possédant une première fréquence à un dispositif photoconducteur recevant de la lumière ;
l'application d'un signal optique, modulé avec ladite première fréquence, audit dispositif photoconducteur recevant de la lumière ;
la génération d'un courant par ledit dispositif photoconducteur recevant de la lumière conformément à un produit dudit signal électrique et dudit signal optique ;
la génération d'une valeur temporelle moyenne dudit courant, ou d'une tension obtenue à partir dudit courant lors d'une conversion ; et
la fourniture de ladite valeur temporelle moyenne, ladite valeur temporelle moyenne étant en fonction de la différence de phase entre ledit signal électrique et ledit signal optique.

2. Procédé selon la revendication 1, comprenant en outre :
la conversion de la valeur du courant généré par ledit dispositif photoconducteur recevant de la lumière en une valeur de tension.

3. Procédé selon la revendication 1, dans lequel, dans ledit dispositif photoconducteur recevant de la lumière, à partir du moment où l'intensité de la lumière incidente est rendue constante et où une tension d'entrée est variée de manière indépendante, la quantité de courant générée par ledit dispositif photoconducteur recevant de la lumière représente une fonction sensiblement impaire de la tension d'entrée appliquée comprenant 0 V, et dans lequel, à partir du moment où la tension d'entrée est rendue constante et où l'intensité de la lumière incidente est variée de manière indépendante, la quantité de courant générée par ledit dispositif photoconducteur recevant de la lumière représente une fonction sensiblement linéaire de l'intensité de la lumière incidente dans une gamme prédéterminée d'intensités de lumière incidente, et
le signal électrique appliqué audit dispositif photoconducteur recevant de la lumière est un signal périodique possédant une moyenne temporelle quasiment nulle, et dans lequel une amplitude du signal électrique représente une fonction temporelle paire lorsque l'origine est définie à un point central entre les moments adjacents auxquels l'amplitude devient nulle.

4. Circuit de détection de différence de phase comprenant :
une unité d'application de tension (200) pour appliquer un signal de tension possédant une première fréquence ;
un dispositif photoconducteur recevant de la lumière (110) étant muni dudit signal de tension et d'un signal optique modulé avec ladite première fréquence, pour générer un courant conformément à un produit dudit signal de tension et dudit signal optique ;
un circuit de moyenne temporelle (130) pour générer et fournir une valeur temporelle moyenne dudit courant, ou d'une tension obtenue à partir dudit courant lors d'une conversion, ladite valeur temporelle moyenne étant en fonction de la différence de phase entre ledit signal de tension et ledit signal optique.

5. Circuit de détection de différence de phase selon la revendication 4, comprenant :
une unité de conversion de courant en tension (120) pour convertir le courant généré par le dispositif photoconducteur recevant de la lumière (110) en une tension.

6. Circuit de détection de différence de phase selon la revendication 4, comprenant en outre un circuit d'ajustement de polarisation (140) pour ajuster une tension de polarisation d'exploitation par rapport audit dispositif photoconducteur recevant de la lumière (110).

7. Circuit de détection de différence de phase selon la revendication 4, dans lequel, dans ledit dispositif photoconducteur recevant de la lumière (110), à partir du moment où l'intensité de la lumière incidente est constante et où une tension d'entrée est une variable indépendante, la quantité de courant générée par ledit dispositif photoconducteur recevant de la lumière (110) représente une fonction sensiblement impaire de la tension d'entrée dans une gamme prédéterminée de tensions d'entrée comprenant 0 V, et dans lequel, à partir du moment où la tension d'entrée est constante et où l'intensité de la lumière incidente est une variable indépendante, la quantité de courant générée par ledit dispositif photoconducteur recevant de la lumière (110) représente une fonction sensiblement linéaire de l'intensité de la lumière incidente dans une gamme prédéterminée d'intensités de lumière incidente.

8. Circuit de détection de différence de phase selon la revendication 7, dans lequel ledit dispositif photoconducteur recevant de la lumière (110) est un photodétecteur possédant une structure métallique en métal/semi-conducteur.

9. Circuit de détection de différence de phase selon la revendication 5, dans lequel ledit circuit de moyennage temporel (130) comprend un circuit de moyennage de tension pour recevoir la tension de la part de ladite unité de conversion de courant en tension (120) afin de générer une valeur moyenne temporelle de celle-ci.

10. Appareil de détection de différence de phase comprenant un circuit de détection de différence de phase selon la revendication 4, dans lequel ladite unité d'application de tension (200) est agencée pour recevoir un signal électrique possédant ladite première fréquence afin d'appliquer ledit signal de tension audit dispositif photoconducteur recevant de la lumière (110).

11. Appareil de détection de différence de phase selon la revendication 10, dans lequel, dans ledit dispositif photoconducteur recevant de la lumière (110), à partir du moment où l'intensité de la lumière incidente est constante et où une tension d'entrée est une variable indépendante, la quantité de courant générée par ledit dispositif photoconducteur recevant de la lumière (110) représente une fonction sensiblement impaire de la tension d'entrée dans une gamme prédéterminée de tensions d'entrée comprenant 0 V, et dans lequel, à partir du moment où la tension d'entrée est constante et où l'intensité de la lumière incidente est une variable indépendante, la quantité de courant générée par ledit dispositif photoconducteur recevant de la lumière (110) représente une fonction sensiblement linéaire de l'intensité de la lumière incidente dans une gamme prédéterminée d'intensités de lumière incidente, et
le signal de tension appliqué par ladite unité d'application de tension (200) est un signal périodique possédant une moyenne temporelle quasiment nulle, et dans lequel l'amplitude du signal de tension représente une fonction temporelle paire lorsque l'origine est définie à un point central entre les moments adjacents auxquels l'amplitude devient nulle.
